# EUROPÄISCHE PATENTANMELDUNG

(11) **EP 2 209 212 A1**
(43) Veröffentlichungstag der Anmeldung: **21.07.2010**
(21) Anmeldenummer: 10000096.7
(22) Anmeldetag: 08.01.2010
(51) Int. Cl.: H03K 17/96

(54) **Berührunggsempfindlicher Tastschalter**

(30) Priorität: 17.01.2009 DE 102009005008
(71) Anmelder: Diehl AKO Stiftung & Co. KG, 88239 Wangen (DE)
(72) Erfinder: Rapp, Harald, 88353 Kisslegg (DE); Prinz, Michael, 88299 Leutkirch (DE); Heimann, Uwe, 88239 Wangen (DE)
(74) Vertreter: Diehl Patentabteilung

(57) **Zusammenfassung**

Ein berührungsempfindlicher Tastschalter, wie beispielsweise ein kapazitiver Berührungsschalter, weist eine Abdeckung (10), die ein Berührungsfeld (12) für einen Benutzer definiert; ein Sensorelement (16-18), das im Bereich des Berührungsfeldes (12) auf der dem Benutzer abgewandten Seite der Abdeckung (10) angeordnet ist; wenigstens eine Lichtquelle (24); und ein Lichtleitelement (26a, 26b) zum Leiten des von der wenigstens einen Lichtquelle (24) ausgesendeten Lichts zum Berührungsfeld (12) der Abdeckung (10), wobei die Abdeckung (10) im Bereich des Berührungsfeldes (12) zumindest teilweise für das von der wenigstens einen Lichtquelle (24) ausgesendete Licht durchlässig ausgebildet ist, auf. Zum Kennzeichnen bzw. Hinterleuchten des Berührungsfeldes (12) für den Benutzer weist das Lichtleitelement (26a, 26b) einen ersten Lichtleifabschnitt (26a), der neben dem Sensorelement (16-18) angeordnet und mit der wenigstens einen Lichtquelle (24) gekoppelt ist, und einen zweiten Lichtleitabschnitt (26b), der im Bereich des Berührungsfeldes (12) zwischen der Abdeckung (10) und dem Sensorelement (16-18) angeordnet und mit dem ersten Lichtleitabschnitt (26a) gekoppelt ist, auf.

## Beschreibung

Die vorliegende Erfindung betrifft einen berührungsempfindlichen Tastschalter nach dem Oberbegriff des Anspruchs 1.

In vielen elektrischen bzw. elektronischen Geräten, insbesondere auch in Haushaltsgeräten wie Herden, Kochfeldern, Mikrowellenöfen, Spülmaschinen, Waschmaschinen, Wäschetrockner und dergleichen, werden häufig berührungsempfindliche Tastschalter eingesetzt, die durch ein einfaches Berühren durch einen Benutzer einen bestimmten Schaltvorgang auslösen und/oder eine Geräteeinstellung ändern.

Im Fall eines kapazitiven Berührungsschalters bildet ein kapazitives Sensorelement zusammen mit zum Beispiel einem Finger eines Benutzers über eine als Dielektrikum wirkende Abdeckung eine Kapazität, die entsprechend dem Betätigen des Tastschalters, d.h. dem Berühren oder Nicht-Berühren eines dem kapazitiven Sensorelement zugeordneten Berührungsfeldes des Abdeckung variabel ist. Die Veränderung des Kapazitätswerts des kapazitiven Sensorelements wirkt sich entsprechend auf ein Ausgangssignal der Sensorschaltung aus, was von einer angeschlossenen Auswerteschaltung als eine Betätigung des kapazitiven Berührungsschalters interpretiert wird.

Damit ein Benutzer die im Allgemeinen mehreren berührungsempfindlichen Tastschalter erkennen und unterscheiden kann, ist die Abdeckung im Bereich ihrer den Sensorelementen zugeordneten Berührungsfelder grafisch und/oder haptisch gekennzeichnet. Solche Designs werden zum Beispiel mit geeigneten Folien auf der dem Benutzer zugewandten Oberseite oder der Unterseite der Abdeckung realisiert. Darüber hinaus besteht häufig auch der Wunsch, die Berührungsfelder der Abdeckung zu beleuchten und auf diese Weise deutlicher zu kennzeichnen.

Aus der DE 103 52 681 A1 ist ein kapazitiver Berührungsschalter bekannt, bei dem das Sensorelement aus einem elektrisch leitfähigen Kunststoff oder Schaumstoff einen zentralen Längskanal aufweist, durch den Licht von einer LED zu einer lichtdurchlässigen Abdeckung gestrahlt wird. Im Fall der EP 0 859 467 A1 ist das Sensorelement des kapazitiven Berührungsschalters, das ebenfalls einen zentralen Durchbruch für eine LED-Beleuchtung aufweist, aus einem flexiblen, elektrisch leitenden Kunststoff- oder Gummimaterial gebildet.

Die DE 10 2005 053 792 A1 beschreibt einen kapazitiven Berührungsschalter mit einem Sensorelement, das ein Kontaktelement und eine Druckfeder jeweils aus einem elektrisch leitenden Material aufweist und mit einer Leiterplatte elektrisch leitend in Kontakt steht. In einer Ausführungsvariante ist der zentrale Haltestift des Sensorelements durch ein Lichtleitelement gebildet, das mit einer LED gekoppelt ist.

Bei den vorgenannten berührungsempfindlichen Tastschaltern erfolgt die Beleuchtung des Berührungsfeldes der Abdeckung jeweils nur in einem zentralen Teilbereich, der durch den für die zentrale Lichtleitung zur Verfügung stehenden Bauraum begrenzt ist.

In der DE 10 2004 025 878 A1 ist ein berührungsempfindlicher Tastschalter mit einem Infrarot-Sender, dem ein erstes Lichtleitelement zugeordnet ist, und einem Infrarot-Empfänger, dem ein zweites Lichtleitelement zugeordnet ist, offenbart. Zusätzlich kann zwischen dem Infrarot-Sender und dem Infrarot-Empfänger eine Leuchtdiode angeordnet sein, deren sichtbares Licht durch beide Lichtleitelemente zur Abdeckung geleitet wird.

Die EP 1 257 057 A1 zeigt einen kapazitiven Berührungsschalter mit einer Sensorfläche an der Unterseite einer Abdeckung, die über einen elastischen Kontaktstift mit der Leiterplatte elektrisch leitend in Kontakt steht. Neben dem Kontaktstift ist auf der Leiterplatte eine LED montiert, die mit einem trichterförmigen Lichtleitelement gekoppelt ist und Licht in Richtung zur Sensorfläche abstrahlt. Zur Kennzeichnung des Berührungsfeldes weist die Sensorfläche eine schlitzartige Ausnehmung auf, durch welche das Licht von der LED hindurch dringen kann. Um die Funktionalität des kapazitiven Sensorelements nicht zu beeinträchtigen, sind die grafischen Darstellungsmöglichkeiten für den hinterleuchteten Schlitz in der Sensorfläche jedoch begrenzt und liegen insbesondere in jedem Fall außermittig.

Weiter offenbart die DE 10 2004 019 304 A1 einen kapazitiven Berührungsschalter mit einem zweiteiligen Sensorelement aus einem flexiblen, elektrisch leitenden Kunststoff- oder Schaumstoffmaterial, das in einem Käfig aus einem transparenten, elektrisch isolierenden Material aufgenommen ist. Diesem Käfig ist eine LED zugeordnet, welche Licht über bestimmte Streben des Käfigs zur Abdeckung aussendet. Da das der Abdeckung zugewandte Sensorelementteil größer als das andere Sensorelementteil dimensioniert ist, ist es möglich, eine flächenmäßig begrenzte Beleuchtung innerhalb des durch das größere Sensorelementteil definierten Berührungsfeldes der Abdeckung, aber konstruktionsbedingt wieder nur außermittig zu erzielen.

Der Erfindung liegt die Aufgabe zugrunde, einen berührungsempfindlichen Tastschalter zu schaffen, der ein beleuchtetes Berührungsfeld mit sehr variablen Gestaltungsmöglichkeiten seiner Kennzeichnung besitzt.

Diese Aufgabe wird gelöst durch einen berührungsempfindlichen Tastschalter mit den Merkmalen des Anspruchs 1. Vorteilhafte Ausgestaltungen und Weiterbildungen der Erfindung sind Gegenstand der abhängigen Ansprüche.

Der berührungsempfindlicher Tastschalter enthält eine Abdeckung, die ein Berührungsfeld für einen Benutzer definiert; ein Sensorelement, das im Bereich des Berührungsfeldes auf der dem Benutzer abgewandten Seite der Abdeckung angeordnet ist; wenigstens eine Lichtquelle; und ein Lichtleitelement zum Leiten des von der wenigstens einen Lichtquelle ausgesendeten Lichts zum Berührungsfeld der Abdeckung, wobei die Abdeckung im Bereich des Berührungsfeldes zumindest teilweise für das von der wenigstens einen Lichtquelle ausgesendete Licht durchlässig ausgebildet ist. Erfindungsgemäß weist das Lichtleitelement einen ersten Lichtleitabschnitt, der neben dem Sensorelement angeordnet und mit der wenigstens einen Lichtquelle gekoppelt ist, und einen zweiten Lichtleitabschnitt, der im Bereich des Berührungsfeldes zwischen der Abdeckung und dem Sensorelement angeordnet und mit dem ersten Lichtleitabschnitt gekoppelt ist, auf.

Das Lichtleitelement des berührungsempfindlichen Tastschalters hat einen ersten Lichtleitabschnitt, der neben dem Sensorelement angeordnet und mit der wenigstens einen Lichtquelle gekoppelt ist. Durch die Anordnung des ersten Lichtleitabschnitts neben dem Sensorelement muss die Ausgestaltung des Sensorelements selbst nicht modifiziert werden, weshalb die Funktionsfähigkeit des Sensorelements nicht beeinträchtigt wird. Insbesondere müssen in dem Sensorelement keinerlei Durchbrechungen zum Zwecke der Lichtleitung eingebracht werden. Darüber hinaus hat das Lichtleitelement des berührungsempfindlichen Tastschalters der Erfindung noch einen zweiten Lichtleitabschnitt, der im Bereich des Berührungsfeldes zwischen der Abdeckung und dem Sensorelement angeordnet und mit dem ersten Lichtleitelement gekoppelt ist. Die Dimensionierung des zweiten Lichtleitabschnitts ist in der Ebene parallel zur Abdeckung praktisch nicht begrenzt, sodass wahlweise das gesamte Berührungsfeld, nur ein Teil des Berührungsfeldes oder sogar mehr als das Berührungsfeld selbst durch das von der wenigstens einen Lichtquelle ausgesendete Licht hinterleuchtet werden kann. Die Gestaltungsmöglichkeiten für die beleuchtete Kennzeichnung des Berührungsfeldes sind dabei praktisch unbegrenzt. Die Funktionalität des Sensorelements wird durch den zweiten Lichtleitabschnitt nicht beeinträchtigt.

In einer bevorzugten Ausführungsform der Erfindung können der erste Lichtleitabschnitt und der zweite Lichtleitabschnitt des Lichtleitelements integral miteinander ausgebildet sein, wodurch die Anzahl einzelner Bauteile reduziert ist.

In einer Ausgestaltung der Erfindung kann zwischen dem ersten und dem zweiten Lichtleitabschnitt eine Reflexionsvorrichtung zum Umlenken des von der wenigstens einen Lichtquelle ausgesendeten Lichts von dem ersten Lichtleitabschnitt in den zweiten Lichtleitabschnitt vorgesehen sein.

In einer noch weiteren Ausgestaltung der Erfindung können in oder an dem zweiten Lichtleitabschnitt eine Umlenkeinrichtung zum Umlenken des von der wenigstens einen Lichtquelle ausgesendeten Lichts von dem zweiten Lichtleitabschnitt in Richtung zum Berührungsfeld der Abdeckung und/oder eine Lichtdiffusionseinrichtung zum Verteilen des von der wenigstens einen Lichtquelle ausgesendeten Lichts zumindest teilweise über den Bereich des Berührungsfeldes der Abdeckung vorgesehen sein. Bevorzugt können diese Umlenkeinrichtung und diese Lichtdiffusionseinrichtung als eine gemeinsame Umlenk- und Diffusionseinrichtung ausgebildet sein.

Gemäß einer weiteren Ausführungsform der Erfindung kann das Lichtleitelement zumindest teilweise von einem Lichtkanalelement zum Verhindern eines unerwünschten Austritts des von der wenigstens einen Lichtquelle ausgesendeten Lichts aus dem Lichtleitelement umgeben sein, sodass ein Strahlungsverlust auf dem Weg von der wenigstens einen Lichtquelle bis zum Berührungsfeld der Abdeckung reduziert bzw. möglichst vermieden wird.

In einer noch weiteren Ausgestaltung der Erfindung kann eine Federeinrichtung zum Drücken des zweiten Lichtleitabschnitts des Lichtleitelements in Richtung zur Abdeckung vorgesehen sein. Diese Federeinrichtung kann vorzugsweise ein Bestandteil des Sensorelements sein.

Ferner kann eine Leiterplatte vorgesehen sein, die sowohl mit dem Sensorelement elektrisch leitend in Kontakt steht und auf der die wenigstens eine Lichtquelle montiert ist. Die wenigstens eine Lichtquelle ist zum Beispiel eine Leuchtdiode zum Aussenden sichtbaren Lichts.

In einer weiteren Ausgestaltung der Erfindung kann im Bereich des Berührungsfeldes der Abdeckung wenigstens ein Grafikelement vorgesehen, das für das von der wenigstens einen Lichtquelle ausgesendete Licht zumindest teilweise durchlässig ausgebildet ist. Durch das Grafikelement lassen sich in einfacher Weise zum Beispiel beleuchtete Symbole und Beschriftungen zum Kennzeichnen des Berührungsfeldes bereitstellen. Dieses wenigstens eine Grafikelement kann zum Beispiel wahlweise in/an der Abdeckung und/oder in/an dem zweiten Lichtleitabschnitt des Lichtleitelements und/oder zwischen der Abdeckung und dem zweiten Lichtleitabschnitt des Lichtleitelements angeordnet bzw. ausgebildet sein.

Der berührungsempfindliche Tastschalter der Erfindung kann als Sensorelement zum Beispiel ein kapazitives Sensorelement, ein induktives Sensorelement, ein piezoelektrisches Sensorelement oder ein Infrarot-Sensorelement enthalten. Beispielsweise kann das Sensorelement eine Sensorplatte aus einem elektrisch leitenden Material, deren Form und Größe im Wesentlichen jenen des Berührungsfeldes der Abdeckung entsprechen, und eine Druckfeder aus einem elektrisch leitenden Material, die mit der Sensorplatte elektrisch leitend in Kontakt steht, aufweisen.

Der berührungsempfindliche Tastschalter gemäß der vorliegenden Erfindung ist in vorteilhafter Weise für Bedienfelder von elektrischen Geräten, insbesondere elektrischen Haushaltsgeräten wie Herden, Kochfeldern, Mikrowellenöfen, Spülmaschinen, Waschmaschinen, Wäschetrockner und dergleichen verwendbar.

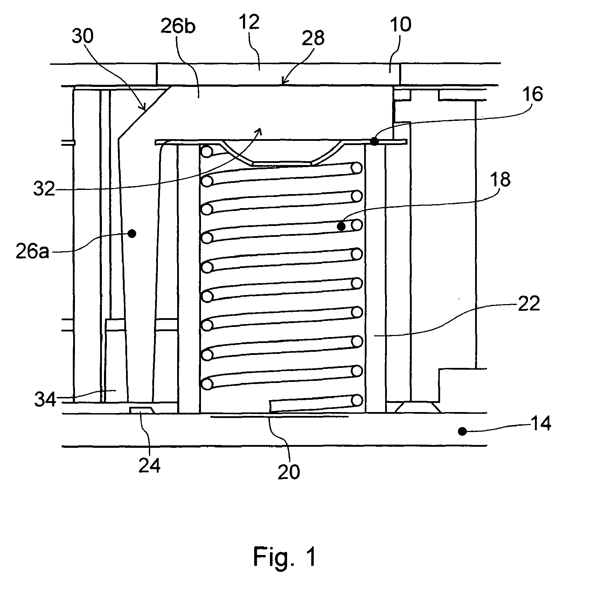

Obige sowie weitere Merkmale, Vorteile und Anwendungsmöglichkeiten der Erfindung werden aus der nachfolgenden Beschreibung eines bevorzugten, nichteinschränkenden Ausführungsbeispiels unter Bezugnahme auf die beiliegenden Zeichnungen besser verständlich. Darin zeigt die einzige Figur beispielhaft eine schematische Schnittansicht eines berührungsempfindlichen Tastschalters gemäß der vorliegenden Erfindung.

Der berührungsempfindliche Tastschalter der Erfindung wird nachfolgend am Beispiel eines kapazitiven Berührungsschalters unter Bezug auf die Figur näher erläutert. Wie bereits oben erwähnt, ist das Konstruktions- bzw. Funktionsprinzip der Erfindung aber analog auch auf berührungsempfindliche Tastschalter mit einem induktiven Sensorelement, einem piezoelektrischen Sensorelement oder einem Infrarot-Sensorelement übertragbar.

Der kapazitive Berührungsschalter des in der Figur dargestellten Ausführungsbeispiels weist eine Abdeckung auf, die aus einem elektrisch nicht leitenden Material wie beispielsweise Glaskeramik oder Kunststoff gebildet ist und ein Berührungsfeld 12 für einen Benutzer definiert. Durch das Berühren des Berührungsfeldes 12 mit einem Finger kann der Benutzer einen diesem Berührungsschalter zugeordneten Schalt- oder Einstellvorgang auslösen.

Auf der dem Benutzer abgewandten Seite der Abdeckung 10 (d.h. unten in der Figur) ist eine Leiterplatte 14 vorgesehen, die in einem bestimmten Abstand zur Abdeckung angeordnet ist. Zwischen der Abdeckung 10 und der Leiterplatte 14 ist ein kapazitives Sensorelement vorgesehen. Das Sensorelement weist eine Sensorplatte 16 aus einem elektrisch leitenden Material (z.B. in Form einer metallischen Scheibe) sowie eine Druckfeder 18 aus einem elektrisch leitenden Material, die sich auf der Leiterplatte 14 abstützt und so die Sensorplatte 16 in Richtung zur Abdeckung 10 (d.h. nach oben in der Figur) zu drücken. Die Druckfeder 18 steht über eine Kontaktfläche 20 mit der Leiterplatte 14 elektrisch leitend in Verbindung. Aufbau und Funktionsweise dieses Sensorelements 16-18 entsprechen im Wesentlichen jenen des in der bereits erwähnten DE 10 2005 053 792 A1 beschriebenen kapazitiven Berührungsschalters. Auf diese Druckschrift wird daher hinsichtlich Aufbau und Funktionsweise des Sensorelements vollinhaltlich Bezug genommen.

Form und Größe der Sensorplatte 16 des kapazitiven Sensorelements 16 - 18 bestimmen im Wesentlichen auch Form und Größe des Berührungsfeldes 12 der Abdeckung 10, wie in der Figur angedeutet.

Das Sensorelement 16 - 18 ist innerhalb einer im Wesentlichen zylindrischen Aufnahme 22 aus einem elektrisch isolierenden Material angeordnet. Diese Aufnahme 22 kann gleichzeitig als Stütz- und Positionierungselement für das Sensorelement 16 - 18 dienen.

Neben dem Sensorelement 16-18 ist auf der Leiterplatte 14 eine Leuchtdiode 24 als Lichtquelle montiert. Wahlweise können auch zwei oder mehr Leuchtdioden 24 für einen kapazitiven Berührungsschalter vorgesehen sein. Die Leuchtdiode 24 sendet sichtbares Licht aus; darüber hinaus ist die Wellenlänge des von der wenigstens einen Lichtquelle 24 ausgesendeten Lichts nicht eingeschränkt.

Das von der wenigstens einen Leuchtdiode 24 ausgesendete Licht wird mit Hilfe eines Lichtleitelements zum Berührungsfeld 12 der Abdeckung 10 geleitet. Zu diesem Zweck weist das Lichtleitelement einen ersten Lichtleitabschnitt 26a und einen zweiten Lichtleitabschnitt 26b auf, die vorzugsweise integral miteinander ausgebildet sind.

Der erste Lichtleitabschnitt 26a des Lichtleitelements ist mit der wenigstens einen Leuchtdiode 24 gekoppelt und verläuft neben dem Sensorelement 16-18 im Wesentlichen senkrecht zwischen der Abdeckung 10 und der Leiterplatte 14. Der zweite Lichtleitabschnitt 26, der über eine Reflexionsvorrichtung 30 mit dem ersten Lichtleitabschnitt 26a gekoppelt ist, ist zwischen der Abdeckung 10 und dem Sensorelement 16-18 angeordnet. Dabei erstreckt sich der zweite Lichtleitabschnitt 26b vorzugsweise im Wesentlichen über den gesamten Bereich des Berührungsfeldes 12 der Abdeckung 10, sodass auch das gesamte Berührungsfeld 12 beleuchtet werden kann. Es können aber ebenso Lichtleitelemente mit einem zweiten Lichtleitabschnitt 26b verwendet werden, dessen Dimensionen kleiner oder größer als jene des Berührungsfeldes 12 der Abdeckung 10 sind. Auch muss der zweite Lichtleitabschnitt nicht notwendigerweise koaxial zur Sensorplatte 16 des Sensorelements und damit zum Berührungsfeld angeordnet sein.

Das Lichtleitelement 26a, 26b ist vorzugsweise aus einem elektrisch nicht leitenden Material gebildet. Die Abdeckung 10 ist zumindest im Bereich des Berührungsfeldes 12 für das von der wenigstens einen Lichtquelle 24 ausgesendete Licht zumindest teilweise durchlässig ausgebildet.

In oder an dem zweiten Lichtleitabschnitt 26b des Lichtleitelements ist in bevorzugter Ausführungsform eine Umlenk- und Diffusionseinrichtung 32 vorgesehen bzw. ausgebildet. Diese Umlenk- und Diffusionseinrichtung 32 soll einerseits das von der wenigstens einen Leuchtdiode 24 ausgesendete Licht in Richtung zur Abdeckung 10 (nach oben in der Figur) umlenken und andererseits eine möglichst gleichmäßige Verteilung des Lichts und damit Hinterleuchtung des Berührungsfeldes 12 bewirken. Diese Einrichtung 32 kann zum Beispiel in Form einer speziell ausgebildeten, zum Beispiel in spezieller Weise reflektierenden Unterseite (d.h. die der Abdeckung abgewandte Seite) des zweiten Lichtleitabschnitts 26b realisiert sein. Dem Fachmann auf dem Gebiet der Lichtleiter sind diesbezüglich diverse Gestaltungsmöglichkeiten bekannt.

Wahlweise können auch eine Umlenkeinrichtung und eine Lichtdiffusionseinrichtung separat voneinander ausgebildet bzw. angeordnet sein. Ebenso kann auch nur eine dieser beiden Einrichtungen vorgesehen sein. Die Lichtdiffusionseinrichtung kann zum Beispiel auch durch ein diffuses Lichtleitermaterial gebildet sein.

Das oben beschriebene Lichtleitelement mit erstem und zweitem Lichtleitabschnitt 26a, 26b eröffnet dem Anwender eine sehr variable Gestaltung der Kennzeichnung bzw. Hinterleuchtung des Berührungsfeldes 12 der Abdeckung 10. Um bei einem gleichen Grundaufbau unterschiedliche Kennzeichnungen zu erzielen, ist es von Vorteil, ein Grafikelement 28 vorzusehen, das zum Beispiel im Bereich eines negativen Grafiksymbols für das von der wenigstens einen Leuchtdiode 24 ausgesendete Licht zumindest teilweise durchlässig ist. Dieses Grafikelement 28 kann zum Beispiel in die Abdeckung 10 integriert sein, in den zweiten Lichtleitabschnitt 26b integriert sein, an der Oberseite der Abdeckung 10 vorgesehen sein, an der Unterseite der Abdeckung 10 vorgesehen sein, an der der Abdeckung 10 zugewandten Seite des zweiten Lichtleitabschnitts 26b vorgesehen sein, zwischen der Abdeckung und dem zweiten Lichtleitabschnitt 26b vorgesehen sein oder an mehreren der vorgenannten Stellen angeordnet bzw. ausgebildet sein.

Um die Effizienz des von der wenigstens einen Leuchtdiode 24 ausgesendeten Lichts zu erhöhen, kann das Lichtleitelement zusätzlich mit einem Lichtkanalelement 34 versehen sein, welches aus einem lichtundurchlässigen Material besteht und das Lichtleitelement 26a, 26b zumindest teilweise umgibt. In dem in der Figur dargestellten Ausführungsbeispiel ist dieses Lichtkanalelement 34 beispielhaft um den ersten Lichtleitabschnitt 26a nahe der wenigstens einen Leuchtdiode 24, d.h. an seinem Einkopplungsende, angeordnet.

Die Druckfeder 18 des kapazitiven Sensorelements 16 - 18 dient gleichzeitig als Federeinrichtung, um das Lichtleitelement, insbesondere seinen zweiten Lichtleitabschnitt 26b in Richtung zur Abdeckung 10 bzw. gegen die Abdeckung 10 zu drücken. Durch diese Federeinrichtung können Luftspalte zwischen dem Lichtleitelement und der Abdeckung sowie auch zwischen der Sensorplatte 16 des Sensorelements und dem zweiten Lichtleitabschnitt 26b des Lichtleitelements vermieden werden, welche die Funktionalität des Berührungsschalters möglicherweise negativ beeinflussen könnten.

### BEZUGSZIFFERNLISTE

- 10: Abdeckung
- 12: Berührungsfeld
- 14: Leiterplatte
- 16: Sensorplatte
- 18: Druckfeder
- 20: Kontaktfläche
- 22: Aufnahme
- 24: Lichtquelle
- 26a: erster Lichtleitabschnitt
- 26b: zweiter Lichtleitabschnitt
- 28: Grafikelement
- 30: Reflexionsvorrichtung
- 32: Umlenk- und Diffusionseinrichtung
- 34: Lichtkanalelement

## Patentansprüche

1. Berührungsempfindlicher Tastschalter, mit
einer Abdeckung (10), die ein Berührungsfeld (12) für einen Benutzer definiert; einem Sensorelement (16-18), das im Bereich des Berührungsfeldes (12) auf der dem Benutzer abgewandten Seite der Abdeckung (10) angeordnet ist; wenigstens einer Lichtquelle (24); und
einem Lichtleitelement (26a, 26b) zum Leiten des von der wenigstens einen Lichtquelle (24) ausgesendeten Lichts zum Berührungsfeld (12) der Abdeckung (10), wobei die Abdeckung (10) im Bereich des Berührungsfeldes (12) zumindest teilweise für das von der wenigstens einen Lichtquelle (24) ausgesendete Licht durchlässig ausgebildet ist,
**dadurch gekennzeichnet,**
**dass** das Lichtleitelement (26a, 26b) einen ersten Lichtleitabschnitt (26a), der neben dem Sensorelement (16-18) angeordnet und mit der wenigstens einen Lichtquelle (24) gekoppelt ist, und einen zweiten Lichtleitabschnitt (26b), der im Bereich des Berührungsfeldes (12) zwischen der Abdeckung (10) und dem Sensorelement (16-18) angeordnet und mit dem ersten Lichtleitabschnitt (26a) gekoppelt ist, aufweist.

2. Berührungsempfindlicher Tastschalter nach Anspruch 1,
**dadurch gekennzeichnet,**
**dass** der erste Lichtleitabschnitt (26a) und der zweite Lichtleitabschnitt (26b) des Lichtleitelements integral miteinander ausgebildet sind.

3. Berührungsempfindlicher Tastschalter nach einem der vorherigen Ansprüche,
**dadurch gekennzeichnet,**
**dass** zwischen dem ersten und dem zweiten Lichtleitabschnitt (26a, 26b) eine Reflexionsvorrichtung (30) zum Umlenken des von der wenigstens einen Lichtquelle (24) ausgesendeten Lichts von dem ersten Lichtleitabschnitt (26a) in den zweiten Lichtleitabschnitt (26b) vorgesehen ist.

4. Berührungsempfindlicher Tastschalter nach einem der vorherigen Ansprüche,
**dadurch gekennzeichnet,**
**dass** in oder an dem zweiten Lichtleitabschnitt (26b) eine Umlenkeinrichtung (32) zum Umlenken des von der wenigstens einen Lichtquelle (24) ausgesendeten Lichts von dem zweiten Lichtleitabschnitt (26a) in Richtung zum Berührungsfeld (12) der Abdeckung (10) vorgesehen ist.

5. Berührungsempfindlicher Tastschalter nach einem der vorherigen Ansprüche,
**dadurch gekennzeichnet,**
**dass** in oder an dem zweiten Lichtleitabschnitt (26b) eine Lichtdiffusionseinrichtung (32) zum Verteilen des von der wenigstens einen Lichtquelle (24) ausgesendeten Lichts zumindest teilweise über den Bereich des Berührungsfeldes (12) der Abdeckung (10) vorgesehen ist.

6. Berührungsempfindlicher Tastschalter nach Anspruch 4 und 4,
**dadurch gekennzeichnet,**
**dass** die Umlenkeinrichtung (32) und die Lichtdiffusionseinrichtung (32) in oder am zweiten Lichtleitabschnitt (26b) des Lichtleitelements als eine gemeinsame Umlenk- und Diffusionseinrichtung ausgebildet sind.

7. Berührungsempfindlicher Tastschalter nach einem der vorherigen Ansprüche,
**dadurch gekennzeichnet,**
**dass** das Lichtleitelement (26a, 26b) zumindest teilweise von einem Lichtkanalelement (34) zum Verhindern eines unerwünschten Austritts des von der wenigstens einen Lichtquelle (24) ausgesendeten Lichts aus dem Lichtleitelement (26a, 26b) umgeben ist.

8. Berührungsempfindlicher Tastschalter nach einem der vorherigen Ansprüche,
**dadurch gekennzeichnet,**
**dass** eine Federeinrichtung (18) zum Drücken des zweiten Lichtleitabschnitts (26b) des Lichtleitelements in Richtung zur Abdeckung (10) vorgesehen ist.

9. Berührungsempfindlicher Tastschalter nach Anspruch 8,
**dadurch gekennzeichnet,**
**dass** die Federeinrichtung (18) ein Bestandteil des Sensorelements (16-18) ist.

10. Berührungsempfindlicher Tastschalter nach einem der vorherigen Ansprüche,
**dadurch gekennzeichnet,**
**dass** eine Leiterplatte (14) vorgesehen ist, die mit dem Sensorelement (16-18) elektrisch leitend in Kontakt steht und auf der die wenigstens eine Lichtquelle (24) montiert ist.

11. Berührungsempfindlicher Tastschalter nach einem der vorherigen Ansprüche,
**dadurch gekennzeichnet,**
**dass** die wenigstens eine Lichtquelle (24) eine Leuchtdiode zum Aussenden sichtbaren Lichts ist.

12. Berührungsempfindlicher Tastschalter nach einem der vorherigen Ansprüche,
**dadurch gekennzeichnet,**
**dass** im Bereich des Berührungsfeldes (12) der Abdeckung (10) wenigstens ein Grafikelement (28) vorgesehen ist, das für das von der wenigstens einen Lichtquelle (24) ausgesendete Licht zumindest teilweise durchlässig ausgebildet ist.

13. Berührungsempfindlicher Tastschalter nach Anspruch 12,
**dadurch gekennzeichnet,**
**dass** das wenigstens eine Grafikelement (28) in/an der Abdeckung (10) und/oder in/an dem zweiten Lichtleitabschnitt (26b) des Lichtleitelements und/oder zwischen der Abdeckung (10) und dem zweiten Lichtleitabschnitt (26b) des Lichtleitelements angeordnet bzw. ausgebildet ist.

14. Berührungsempfindlicher Tastschalter nach einem der vorherigen Ansprüche,
**dadurch gekennzeichnet,**
**dass** das Sensorelement (16-18) ein kapazitives Sensorelement, ein induktives Sensorelement, ein piezoelektrisches Sensorelement oder ein Infrarot-Sensorelement ist.

15. Berührungsempfindlicher Tastschalter nach Anspruch 14,
**dadurch gekennzeichnet,**
**dass** das Sensorelement (16-18) eine Sensorplatte (16) aus einem elektrisch leitenden Material, deren Form und Größe im Wesentlichen jenen des Berührungsfeldes (12) der Abdeckung (10) entsprechen, und eine Druckfeder (18) aus einem elektrisch leitenden Material, die mit der Sensorplatte (16) elektrisch leitend in Kontakt steht, aufweist.
